# EUROPEAN PATENT APPLICATION

(11) **EP 1 318 207 A1**
(43) Date of publication of application: **11.06.2003**
(21) Application number: 01961233.2
(22) Date of filing: 30.08.2001
(51) Int. Cl.: C23C 14/24

(54) **SILICON MONOXIDE VAPOR DEPOSITION MATERIAL, PROCESS FOR PRODUCING THE SAME, RAW MATERIAL FOR PRODUCING THE SAME, AND PRODUCTION APPARATUS**

(30) Priority: 31.08.2000 JP 2000262572; 21.09.2000 JP 2000286581; 23.04.2001 JP 2001124091
(71) Applicant: Sumitomo Titanium Corporation, Amagasaki-shi, Hyogo 660-8533 (JP)
(72) Inventor: ARIMOTO, Nobuhiro, Amagasaki-shi, Hyogo 660-0077 (JP); NISHIOKA, Kazuo, Itami-shi, Hyogo 664-0027 (JP); KIZAKI, Shingo, Neyagawa-shi, Osaka 572-0021 (JP); OGASAWARA, Tadashi, Nishinomiya-shi, Hyogo 663-8181 (JP); FUJITA, Makoto, Ashiya-shi, Hyogo 659-0053 (JP)
(74) Representative: Butler, Lance
(86) International application number: JP0107510
(87) International publication number: WO02018669

(57) **Abstract**

A high-purity silicon monoxide vapor deposition material which, in the formation of a film by vapor deposition, is effective in inhibiting splashino, and which has an average bulk density of 2.0 g/cml and a Vickers hardness of 500 or hiolier; a process for producing a high-purity silicon monoxide vapor deposition mate-rial consisting of SiO and metal impurities as the remainder, the total amount of the impurities beinc, 50 ppm or smaller, which comprises conducting a degassinc, treatment in a raw-material chamber at a temperature lower than the sublimation temperature of silicon monoxide, raising the temperature to sublimate silicon monoxide, and depositing the silicon monoxide on a substrate in a deposition chamber and a raw material for the silicon monoxide vapor deposition material which comprises silicon metal particles and silicon dioxide particles, the average particle size of each particulate material being I to 40 µm and/or the two particulate

## Description

### TECHNICAL FIELD

The present invention relates to a silicon monoxide vapor deposition material as a film formation raw material for forming a silicon oxide vapor-deposited film that is capable of bestowing an excellent gas barrier ability to packaging film materials for foodstuffs, medicines, medical supplies and so on, and in particular to a silicon monoxide vapor deposition material, and a process and apparatus for producing the same, according to which the vapor deposition material can be produced efficiently, splashing that occurs when forming a vapor-deposited film on a film material can be reduced or prevented, and it becomes possible to form a silicon oxide vapor-deposited film of high quality and high purity.

### BACKGROUND ART

With foodstuffs, there are demands to prevent the degradation of fats and proteins contained therein, for example to inhibit degradation in quality due to oxidation caused by oxygen, water vapor, aromatic gases and so on passing through a packaging material.

Moreover, with medical supplies and medicines as well, there are demands to prevent contamination of stored articles from the atmosphere and inhibit degeneration and degradation to a yet higher standard, and moreover there are demands to make a vapor-deposited film itself of high purity so as not to contain impurities.

Packaging materials for protecting such foodstuffs, medical supplies, medicines and so on are required to have a gas barrier ability such that various gases that would bring about oxidation of the stored article are not allowed to pass through, for example packaging materials having aluminum foil or an aluminum vapor-deposited film on paper or a polymer film have been used.

These days, with recycling of packaging materials being promoted, because with the above-mentioned packaging materials having aluminum foil or an aluminum vapor-deposited film it is required to separate the metal and the paper or resin film from one another for reuse, there are calls for packaging materials comprising a material for which such separation recovery is not needed.

For example, packaging materials having a silicon monoxide vapor-deposited film on a polymer film have received attention, not only because recovery treatment merely as a resin film is possible, but also because a silicon monoxide vapor-deposited film has an excellent gas barrier ability.

Such a packaging material is produced by sublimating a silicon monoxide vapor deposition material using a resistive heating vapor deposition method or an electron beam heating vapor deposition method, and vapor-depositing the sublimated gas onto a polymer film.

As a process for producing the packaging material, a vapor deposition raw material is sublimated and a film thereof is formed on a substrate by vapor deposition, and hence the properties of the vapor deposition raw material, and the atmosphere and conditions of the sublimation and vapor deposition are important.

That is, when producing a packaging material having a silicon monoxide vapor-deposited film using a silicon monoxide vapor deposition material, if un-sublimated high-temperature fine silicon monoxide particles fly around, then a problem will arise in that defects such as pinholes will arise in the uniform silicon monoxide film, and hence the gas barrier ability of the vapor-deposited film will be degraded. The phenomenon of un-sublimated fine silicon monoxide particles flying around is called 'splashing'.

From long ago, the silicon monoxide vapor deposition material that is the raw material has been produced by a process in which silicon (Si) powder and quartz (SiO₂) powder are kneaded together and put into a suitable crucible, the temperature is raised to 1300 C in a vacuum, and the silicon monoxide gas generated is recovered by condensing onto a cooled wall, as disclosed in Japanese Patent Publication No. 40-22050. That is, the silicon monoxide vapor deposition material is produced using a vacuum deposition method, and hence the reaction rate of the raw material powder is approximately 80% or less, and thus efficient production has not been possible.

Moreover, a process in which a material obtained by carrying out dry mixing of Si powder and SiO₂ powder, pressure-forming and sintering is used as a silicon monoxide (SiO) vapor deposition material (Japanese Patent Application Laid-open No. 63-310961), and a process in which a material obtained by mixing together Si powder, SiO₂ powder, a basic alkali metal compound such as sodium silicate, and a medium such as water to produce a clay-like mixture, foam-molding using the hydrogen gas generated, and drying and then baking is used as an SiO vapor deposition material (Japanese Patent Application Laid-open No. 4-353531) have been proposed; relatively cheap production is possible, but splashing cannot be sufficiently inhibited.

Moreover, as shown in Japanese Patent Application Laid-open No. 9-143689, a process in which wet-molding is carried out on a slurry containing Si powder and SiO₂ powder, gelation is carried out during the molding, and the molded article obtained is dried and baked, that is a process in which a porous vapor deposition material having a closed porosity of 10% or less and a bulk density of 30 to 70% of the true density is obtained, has been proposed; the occurrence of the above-mentioned splashing can be inhibited with this vapor deposition material, but still not sufficiently.

### DISCLOSURE OF THE INVENTION

It is an object of the present invention to obtain a silicon monoxide vapor deposition material using a vacuum deposition method, and to improve the reaction efficiency, improve the stability and improve the mass production ability.

Moreover, it is an object of the present invention to efficiently produce a silicon monoxide vapor deposition material from which can be obtained a silicon monoxide vapor-deposited film having a low amount of impurities, in particular a markedly reduced content of impurities including As, Cd, Hg, Sb, Pb and so on that are harmful to the human body, as required for packaging materials used in the fields of foodstuffs, medical supplies, medicines and so on.

Moreover, it is an object of the present invention to provide a silicon monoxide vapor deposition material and a process for producing the same, according to which splashing can be inhibited when obtaining a silicon oxide vapor-deposited film having an excellent gas barrier ability.

With objects of producing, using a vacuum deposition method, a silicon monoxide vapor deposition material having a constitution such that splashing, which is prone to occurring when forming a silicon oxide vapor-deposited film, can be inhibited, and improving the reaction efficiency of vacuum deposition when obtaining the silicon monoxide vapor deposition material using the vacuum deposition method, the present inventors carried out various studies into the properties such as the particle size of the raw material powder, the conditions of the vacuum deposition and so on, and as a result discovered that the particle size and the mixing ratio of the raw material greatly affect the reaction efficiency, and furthermore that splashing also occurs during the vacuum deposition when obtaining the vapor deposition material, this being due to the particle size of the raw material powder, gas and so on, and this splashing causes a change in the structure and properties of the silicon monoxide vapor deposition material obtained.

The present inventors carried out further studies with regard to the point that the particle size and the mixing ratio of the raw material greatly affect the reaction efficiency, and as a result discovered that by making the average particle size be in a certain range, or by limiting the molar ratio (silicon dioxide / metallic silicon) of the metallic silicon powder and silicon dioxide powder mixed together to be in a certain range, a high-Quality vapor deposition material can be produced efficiently with a high reaction rate.

That is, the present inventors discovered that, when producing a silicon monoxide vapor deposition material using a vacuum deposition method, by using metallic silicon powder and silicon dioxide powder each having an average particle size in a range of 1 µm to 40 µm, or by making the molar ratio (silicon dioxide/metallic silicon) of the metallic silicon powder and silicon dioxide powder be in a range of 0.90 to 0.99, or by making both the average particle size range and the molar ratio be as specified above, a high-quality vapor deposition material can be produced efficiently with a high reaction rate.

Moreover, the present inventors carried out detailed studies into the occurrence of splashing due to the particle size of the raw material powder, gas and so on during the vacuum deposition when obtaining the vapor deposition material, and as a result discovered that if splashing occurs in the raw material chamber, then the unreacted fine powder generated may enter the deposition chamber, and exert an adverse effect on the quality of the silicon monoxide vapor deposition material produced in the deposition chamber; on the other hand, if the raw material is of high purity, then there should be little problem in terms of Quality due to unreacted fine powder generated through splashing, and yet to obtain a good sublimation reaction it is necessary to mix together SiO₂ powder and Si powder obtained by mechanically pulverizing semiconductor silicon wafers and then carry out wet granulation and drying, and some degree of contamination is unavoidable during this process, and thus impurities are carried into the silicon monoxide vapor deposition material obtained due to splashing in the raw material chamber.

The present inventors thus discovered that to prevent impurities from being contained in the silicon monoxide vapor deposition material obtained, one should inhibit the unreacted fine powder generated through splashing arising in the raw material chamber from being blown around by the energy when the splashing arises and getting into the deposition chamber; the present inventors discovered that, for example, by providing a perforated passage such as a partition member between the raw material chamber and the deposition chamber of the vacuum deposition apparatus, it is possible to remove unreacted fine powder, and thus prevent unreacted fine powder generated through splashing from getting into the deposition chamber, and hence a high-purity silicon monoxide vapor deposition material having a total amount of metallic impurities of 50ppm or less can be produced.

The present inventors carried out further detailed studies into the occurrence of splashing due to the particle size of the raw material powder, gas and so on during the vacuum deposition when obtaining the vapor deposition material, and as a result discovered that if degassing treatment is carried out before the sublimation and thus the splashing and so on is prevented and hence a silicon monoxide vapor deposition material having a prescribed high average bulk density and a prescribed high hardness such as to be able to withstand thermal shock is obtained, then if silicon oxide is deposited using this vapor deposition material, then splashing in which un-sublimated high-temperature fine silicon monoxide particles fly around can be prevented.

The present inventors thus carried out detailed studies into the degassing treatment process, and as a result discovered that when producing the silicon monoxide vapor deposition material, by carrying out degassing treatment on the raw material by holding the temperature in the raw material chamber for 0.5 to 4.0 hours in a range of 800 to 1200°C, which is lower than the sublimation reaction temperature of silicon monoxide, and then raising the temperature to a range of 1300 to 1400°C to sublimate silicon monoxide, attachment onto the deposition substrate becomes good, and a high-bulk-density, high-hardness silicon monoxide vapor deposition material having an average bulk density of 2.0g/cm³ or more and a Vickers hardness of 500 or more can be obtained.

Furthermore, the present inventors discovered that the above-mentioned process capable of realizing a high reaction rate, process in which a high-purity silicon monoxide vapor deposition material is obtained, and process in which a high-bulk-density, high-hardness silicon monoxide vapor deposition material is obtained are also effective in the case of any combination of the processes, and that it is possible to combine all of these processes and thus efficiently produce a high-purity, high-bulk-density, high-hardness silicon monoxide vapor deposition material.

Furthermore, the present inventors discovered that with a silicon monoxide vapor deposition material having high bulk density and high hardness, and also possibly high purity, obtained using the above-mentioned process(es), the occurrence of splashing when forming a silicon oxide vapor-deposited film using a vacuum deposition method can be inhibited; the present inventors thus accomplished the present invention.

### BRIEF DESCRIPTION OF THE DRAWINGS

Fig. 1 is a longitudinal sectional view showing an example of a production apparatus used when producing a silicon monoxide vapor deposition material according to the present invention.
Fig. 2 is a longitudinal sectional view showing an example of a production apparatus used when producing a high-purity silicon monoxide vapor deposition material according to the present invention.
Figs. 3 are explanatory views showing details of a partition member in the production apparatus of Fig. 2; Fig. 3A is a longitudinal sectional view, and Fig. 3B is a bottom view.
Figs. 4 are explanatory views showing another example of the constitution of the partition member in the production apparatus of Fig. 2; Fig. 4A is a perspective view, and Fig. 4B is a plan view.

### BEST MODE FOR CARRYING OUT THE INVENTION

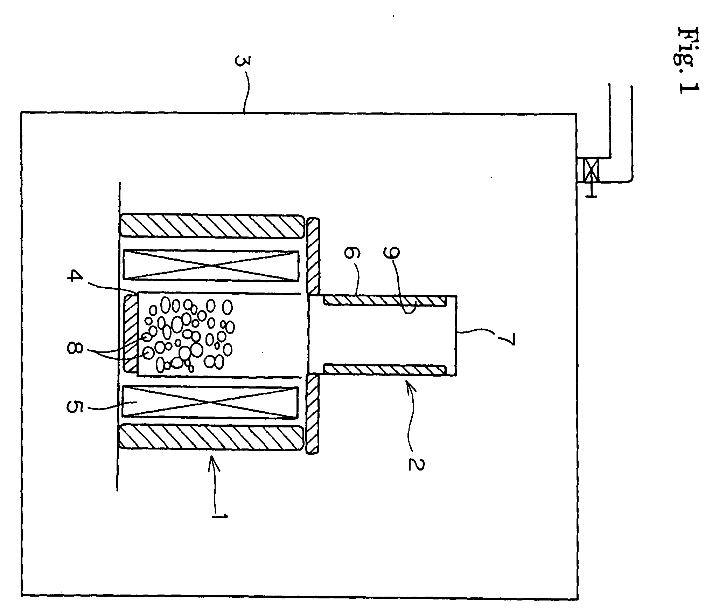

An example of a production apparatus used when producing a silicon monoxide vapor deposition material according to the present invention, that is a vacuum deposition apparatus that uses resistive heating, will now be described with reference to Fig. 1. An apparatus main body installed in a vacuum chamber 3 that constitutes the vacuum deposition apparatus is constituted from a combination of a raw material chamber 1 and a deposition chamber 2 thereabove.

In the raw material chamber 1, a cylindrical raw material vessel 4 is installed in the center of a cylindrical body, and a heat source 5 comprising, for example, an electric heater is disposed around the raw material vessel 4. The deposition chamber 2, which is a cylindrical body, has a stainless steel deposition substrate 6 attached to an inner peripheral surface thereof, and gaseous silicon monoxide sublimated in the raw material vessel 4 of the raw material chamber 1 is vapor-deposited onto the deposition substrate 6. Moreover, a lid 7 is provided detachably at an upper end of the deposition chamber 2. There are holes, not shown, in the lid 7, so that gas can pass through between the deposition chamber 2 and the vacuum chamber 3.

A mixed granulated raw material 8 of metallic silicon powder and silicon dioxide powder is filled into the raw material vessel 4, and heating is carried out in a vacuum to sublimate silicon monoxide, whereby the gaseous silicon monoxide generated rises up from the raw material chamber 1 and enters the deposition chamber 2, and is vapor-deposited onto the deposition substrate 6 around the deposition chamber 2, thus forming deposited silicon monoxide 9.

Here, regarding the particle size of the metallic silicon powder and the silicon dioxide powder that constitute the raw material, the smaller the particle size the faster the reaction speed, but in the case that powders of average particle size less than 1 m are used, some of the unreacted metallic silicon powder and silicon dioxide powder may get into the silicon monoxide 9 vapor deposition material deposited on the deposition substrate 6. This is because unreacted fine powder generated through splashing during the reaction in the raw material chamber 1 will ride on the gas flow of the gaseous silicon monoxide produced through the reaction and be carried to the deposition substrate 6.

Regarding the particle sizes of the raw material powders, if the average particle size exceeds 40µm, then because the particle size is too large, the contact area between the metallic silicon powder and the silicon dioxide powder will become small. The reaction between the metallic silicon and the silicon dioxide in the raw material chamber 1 is a solid phase reaction, and hence the above-mentioned contact area affects the reaction speed. Consequently, if the contact area is small, then the reaction speed will become slow, and thus the deposition amount per unit time will drop.

By using a powder having an average particle size in a range of 1 µm to 40µm for both the metallic silicon powder and the silicon dioxide powder that constitute the raw material, the reaction efficiency can thus be raised. More preferably, the average particle size is in a range of 5µm to 30 µm.

Conventionally, considering the chemical formula of SiO, regarding the mixing ratio between the metallic silicon powder and the silicon dioxide powder that constitute the raw material, the mixing has been carried out with a molar ratio (silicon dioxide / metallic silicon) of 1.0. However, when producing a granulated body, an oxide film is formed on the surface of the metallic silicon powder, and hence the oxygen concentration in the granulated body rises. Consequently, for improving the reaction efficiency, it is preferable to make the mixing ratio be a molar ratio of less than 1.0. The present inventors have discovered from the results of experiments that by making the molar ratio be 0.90 to 0.99, the ratio of Si to 0 in the raw material can be made to approach 1:1.

Regarding the above-mentioned granulated body, if the average particle size is too small at less than 1mm, then the gas flow in the raw material chamber will become poor, and hence the gas produced in the reaction will break up the granulated body, resulting in unreacted fine powder being carried into the deposition chamber. Conversely, if the average particle size is too big at more than 30mm, then the granulating time and the drying time will become long. It is thus preferable for the average particle size of the granulated body to be in a range of 1 to 30mm.

To produce a silicon monoxide vapor deposition material of high bulk density and high hardness, first, a mixed granulated body of metallic silicon and a silicon oxide, or solid silicon monoxide, is heated and thus vaporized in the apparatus described above, but before heating to the sublimation reaction temperature of 1300°C or above, degassing treatment is carried out on the raw material by holding for 0.5 to 4.0 hours in a range of 800 to 1200°C.

With silicon monoxide obtained by carrying out degassing treatment before the sublimation in this way, attachment to the deposition substrate 6 is good, a homogenous silicon monoxide vapor-deposited film can be formed, and a silicon oxide vapor deposition material of high bulk density and high hardness can be produced.

Regarding the degassing treatment temperature, at less than 800°C the degassing takes too much time, and hence the treatment cannot be carried out efficiently, and at above 1200°C silicon monoxide gas starts to be generated before the degassing is completed, and hence the effect of the degassing cannot be obtained sufficiently; the degassing treatment temperature is thus made to be in a range of 800 to 1200°C.

Regarding the holding time during the degassing treatment, at least 0.5 hours is required for the degassing to proceed sufficiently; the lower the heating temperature, and the larger the amount of raw material, the longer the holding time becomes, and conversely the higher the heating temperature, and the lower the amount of raw material, the shorter the holding time becomes, but it is not necessary to hold for more than 4.0 hours.

Regarding the temperature of the sublimation reaction after the degassing treatment, at less than 1300°C, the silicon powder and the silicon dioxide powder will not react sufficiently, but at more than 1400°C, there will be a risk of the melting point of silicon, 1412°C, being exceeded; it is thus preferable for the reaction temperature to be 1300 to 1400°C.

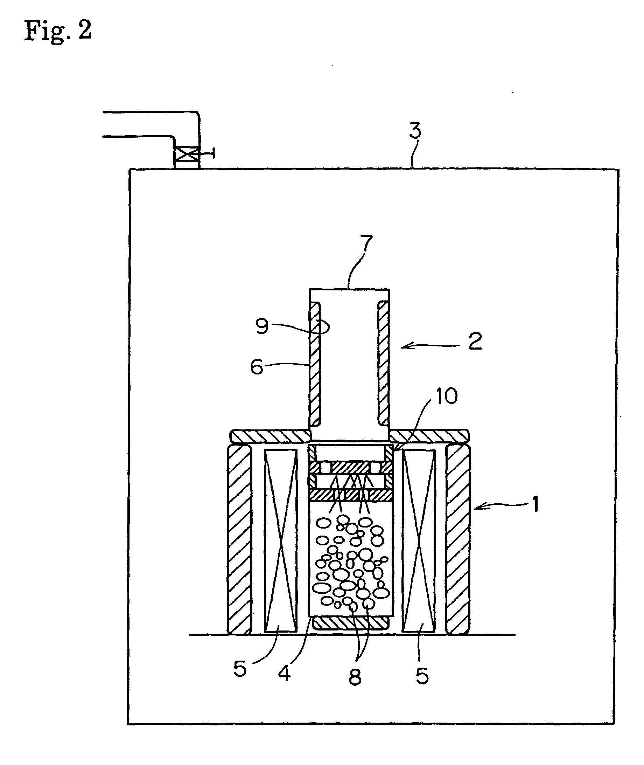

Next, to produce a high-purity silicon monoxide vapor deposition material having the total amount of metallic impurities, including metals that are harmful to the human body, reduced to 50ppm or less, the vacuum deposition apparatus shown in Fig. 2 is used. The basic structure of the furnace is the same as with the apparatus shown in Fig. 1, but a partition member 10 for preventing unreacted fine powder generated through splashing arising in the raw material vessel 4 from getting into the deposition chamber 2 is provided in an upper part of the raw material vessel 4 close to the entrance of the deposition chamber 2.

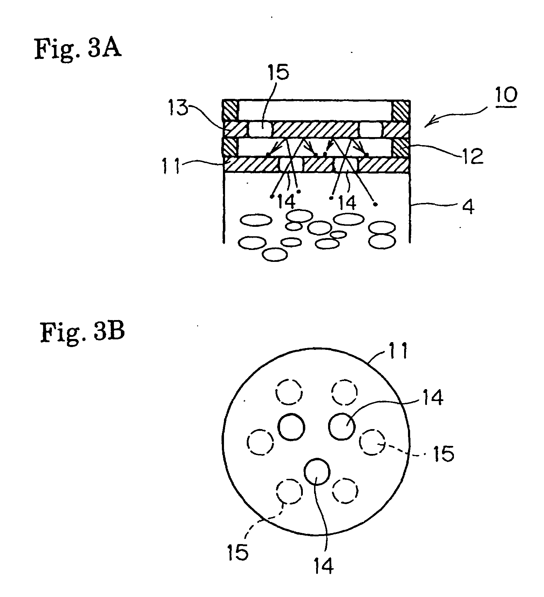

As shown in Figs. 3A and 3B, the partition member 10 disposed in the raw material vessel 4 has a constitution in which an upper partition plate 13 in which six gas flow holes 15 are provided toward the periphery of a circular plate is placed upon a lower partition plate 11 in which three gas flow holes 14 are provided in a central part of a circular plate, with a spacing-maintaining ring 12 interposed therebetween .

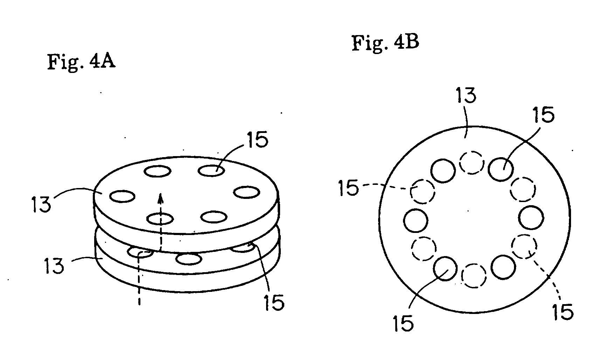

Moreover, as shown in Figs. 4, a constitution is also possible in which two upper partition plates 12 are used and are placed on top of one another with a spacing-maintaining ring 13 interposed therebetween, and staggering is carried out by rotating in the circumferential direction such that the six gas flow holes 15 in each of the circular plates do not communicate with each other.

The above-mentioned partition member 10 can be constituted from a single plate that is a graphite plate or a carbon molded body having a large number of gas flow holes formed therein, or a plurality of such plates combined above and below one another with spacing therebetween. Moreover, plates comprising a porous material of tantalum, molybdenum or the like with no holes formed therein can be used.

The gas flow holes 14 and 15 are flow holes for allowing the passage into the deposition chamber 2 of the silicon monoxide gas sublimated in the raw material vessel 4; the partition plate thickness and the flow hole diameter are selected as appropriate such that unreacted fine powder generated through splashing arising in the raw material chamber can be blocked from getting into the deposition chamber.

Moreover, in the case that a plurality of plates are combined, by providing spacing as appropriate between the plates, and staggering the positions of the gas flow holes between the upper and lower plates as shown in the diagrams, the effect of blocking unreacted fine powder generated through splashing from getting into the deposition chamber can be further improved. In short, by passing the sublimated gas into and through the perforated passage as described above, unreacted fine powder is removed.

Furthermore, through the interposition of the partition member 10, an effect is produced whereby the uniformity of the temperature in the raw material vessel 4 is increased, and the reaction speed of the raw material 8 is raised.

If a silicon monoxide vapor deposition material is produced using the production apparatus having the partition member, then unreacted fine powder generated through splashing arising in the raw material chamber is removed by the partition member, and thus can be prevented from flying onto the deposition substrate 6 in the deposition chamber 2.

Consequently, silicon monoxide having a low amount of metallic impurities is attached uniformly onto the deposition substrate 6, i.e. it is possible to form a high-purity silicon monoxide vapor deposition material for which the total amount of Fe, Al, Ca, Cu, Cr, Mn, Mg, Ti, Ni, P, As, Cd, Hg, Sb and Pb is 50ppm or less.

### Examples

### Examples 1

Using Si powder obtained by mechanically pulverizing semiconductor silicon wafers as the metallic silicon powder, this was blended in various ratios with commercially sold silicon dioxide powder, and wet granulation was carried out using pure water. The granulated raw material was dried, thus obtaining a mixed granulated body.

With the production apparatus shown in Fig. 1, the mixed granulated body was filled into the raw material vessel 4 as the raw material, before heating a vacuum state of pressure approximately 0.1Pa was produced through evacuation, and then a current was passed through the heat source 5 in the vacuum chamber 3, thus heating the inside of the raw material chamber 1 to 800 to 1200°C and then maintaining this temperature while evacuating, and the raw material was held in this state for 2 hours, thus carrying out degassing treatment.

It was then confirmed that the degassing treatment had been completed and that a prescribed degree of vacuum was being maintained, and then raising of the temperature was once again commenced, and, while evacuating, the chamber temperature was raised to 1300 to 1400°C, thus commencing reaction. During the reaction, because a large amount of gaseous silicon monoxide is generated from the raw material, the pressure at the chamber temperature increased naturally. The pressure during the reaction became approximately 60 to 100Pa.

The generated gaseous silicon monoxide rose up from the raw material chamber 1 and entered the deposition chamber 2, and here was vapor-deposited onto the deposition substrate 6. In this way, a silicon monoxide vapor deposition material was obtained.

Note that the average particle size of the metallic silicon powder and the silicon dioxide powder was changed within a range of 0.8 µm to 50 µ m, including the comparative examples, and the blending was carried out with various mixing ratios in a range of 0.86 to 1.0 as a molar ratio.

The pulverization of the metallic silicon and the silicon dioxide that constitute the raw material is carried out using a ball mill or the like, but after the pulverization the average particle size is made uniform using a sieve. Moreover, if, for example, the relationship between the pulverization time using the ball mill and the average particle size is measured in advance, then the required average particle size can be obtained by controlling the pulverization time.

The presence of unreacted silicon and silicon dioxide in the silicon monoxide vapor deposition material obtained can be determined through whether or not peaks are present in X-ray diffraction. As a result of investigating using X-ray diffraction, X-ray peaks for silicon and silicon dioxide were hardly present at a raw material powder average particle size of 1 µm or more, and were not present at all at 5 µm or more. The raw material powder particle size was measured using a Horiba LA-700 (trade name) laser analysis scattering type particle size distribution measuring apparatus. The test results are shown in Table 1.

From the test results in Table 1, it can be seen that for all of the samples for which the present invention was implemented, the reaction rate was 90% or more, which is higher than for samples nos. 10 and 11 of the comparative examples. In particular, it can be seen that the reaction rate was exceptionally high for samples nos. 7 to 9 of the present invention, for which the conditions on both the particle size and the molar ratio of the raw material were satisfied.

**Table 1**

| | No. | Particle size (µm) | Raw material mixing Molar ratio | Reaction rate(%) Deposited amount / raw material |
|---|---|---|---|---|
| Present invention | 1 | 1 | 1 | 90 |
| | 2 | 10 | 1 | 93 |
| | 3 | 40 | 1 | 90 |
| | 4 | 50 | 0.9 | 91 |
| | 5 | 50 | 0.95 | 96 |
| | 6 | 50 | 0.98 | 93 |
| | 7 | 8 | 0.93 | 97 |
| | 8 | 20 | 0.95 | 99 |
| | 9 | 30 | 0.99 | 95 |
| Comparative examples | 10 | 0.8 | 0.86 | 70 |
| | 11 | 50 | 1 | 82 |

### Examples 2

Silicon powder (average particle size 10 µm) obtained by mechanically pulverizing scrap semiconductor silicon wafers arising in another production process, and commercially sold silicon dioxide powder (average particle size 10 µm) were blended together in a molar ratio (silicon dioxide/metallic silicon) of 1, and wet granulation was carried out using pure water. The granulated raw material was dried, thus obtaining a mixed granulated body.

With the production apparatus shown in Fig. 1, the mixed granulated body was filled into the raw material vessel 4 as the raw material, before heating a vacuum state of pressure approximately 0.1Pa was produced through evacuation, and then a current was passed through the heat source 5 in the vacuum chamber 3, thus heating the inside of the raw material chamber 1 to 800 to 1200°C and then maintaining this temperature while evacuating, and the raw material was held in this state for 2 hours, thus carrying out degassing treatment.

It was then confirmed that the degassing treatment had been completed and that a prescribed degree of vacuum was being maintained, and then raising the temperature was once again commenced, and, while evacuating, the chamber temperature was raised to 1300 to 1400°C, thus commencing reaction. During the reaction, because a large amount of gaseous silicon monoxide is generated from the raw material, the pressure at the chamber temperature increased naturally. The pressure during the reaction became approximately 60 to 100Pa.

The generated gaseous silicon monoxide rose up from the raw material chamber 1 and entered the deposition chamber 2, and here was vapor-deposited onto the deposition substrate 6. In this way, a silicon monoxide vapor deposition material was obtained.

The bulk density of the silicon monoxide vapor deposition material obtained was measured using an Archimedean method. Moreover, the hardness was measured at a test load of 200g using a Vickers hardness testing machine (trade name: model MVK-GI made by Akashi Corporation), this being after polishing the vapor deposition material.

For comparative examples, a silicon monoxide vapor deposition material was obtained using the same process as in Examples 2, except that the step of heating to 800 to 1200°C was omitted.

Furthermore, using each silicon monoxide vapor deposition material obtained, vacuum deposition was carried out, and the situation with regard to the occurrence of splashing was investigated. The results are shown in Table 2.

**Table 2**

| | No. | Degassing temperature °C | Bulk density (g/cm³) | Hardness (Hv) | Splashing |
|---|---|---|---|---|---|
| Present invention | 1 | 800 | 2.12 | 530 | ○Seldom occurs |
| | 2 | 1000 | 2.19 | 600 | ⓞNot observed |
| | 3 | 1200 | 2.23 | 680 | ⓞNot observed |
| Comparative examples | 4 | - | 1.95 | 470 | ×Occurs severely |
| | 5 | - | 1.92 | 490 | Δ Some times occurs |

### Examples 3

Silicon powder (average particle size 10 µm) obtained by mechanically pulverizing scrap semiconductor silicon wafers arising in another production process, and commercially sold silicon dioxide powder (average particle size 10 µm) were blended together in a molar ratio (silicon dioxide/metallic silicon) of 1, and wet granulation was carried out using pure water. The granulated raw material was dried, thus obtaining a mixed granulated body.

With the production apparatus shown in Fig. 2, the mixed granulated body was filled into the raw material vessel 4 as the raw material, before heating a vacuum state of pressure approximately 0.1Pa was produced through evacuation, and then a current was passed through the heat source 5 in the vacuum chamber 3, thus heating the inside of the raw material chamber 1 to 800 to 1200°C and then maintaining this temperature while evacuating, and the raw material was held in this state for 2 hours, thus carrying out degassing treatment.

It was then confirmed that the degassing treatment had been completed and that a prescribed degree of vacuum was being maintained, and then raising the temperature was once again commenced, and, while evacuating, the chamber temperature was raised to 1300 to 1400°C, thus commencing reaction. During the reaction, because a large amount of gaseous silicon monoxide is generated from the raw material, the pressure at the chamber temperature increased naturally. The pressure during the reaction became approximately 60 to 100Pa.

The generated gaseous silicon monoxide rose up from the raw material chamber I and entered the deposition chamber 2, and here was vapor-deposited onto the deposition substrate 6. In this way, a silicon monoxide vapor deposition material was obtained.

The partition member used was one in which upper and lower partition plates having a diameter of 304mm and a thickness of 10mm and having near the outer periphery thereof eight gas flow holes of diameter 30mm provided on a circle 107mm from the plate center were made to face one another in an up/down direction with a spacing of 10mm therebetween, and the hole positions of the gas flow holes in each of the plates were staggered in the circumferential direction of the plates.

A sample was taken from each of the plurality of silicon monoxide vapor deposition materials obtained, and analysis of the metallic impurities was carried out on each of the samples using an ICP emission spectroscopy method. an atomic absorption spectrophotometry method, and an absorption spectrophotometry method. The results are shown in Table 3.

From the test results of Table 3, it can be seen that for all of samples nos. 1 to 5 for which the present invention was implemented, the total metallic impurity concentration was less than 50ppm. In particular, for samples nos. 4 and 5, which were produced with an apparatus using a partition member comprising two partition plates disposed above and below one another, the metallic impurity concentration was less than 35ppm. In contrast, for all of samples nos. 6 to 9 of comparative examples, which were produced with a conventional apparatus not having a partition member, the total metallic impurity concentration was more than 120ppm.

From these results, it can be seen that by using a partition member according to implementation of the present invention, there is a marked effect of reducing the amount of metallic impurities in the silicon monoxide vapor deposition material. Moreover, it can be seen that a silicon monoxide vapor deposition material produced according to implementation of the present invention has a markedly reduced metallic impurity content, and is thus an ideal vapor deposition material for use as a packaging material in the fields of foodstuffs, medicines and so on.

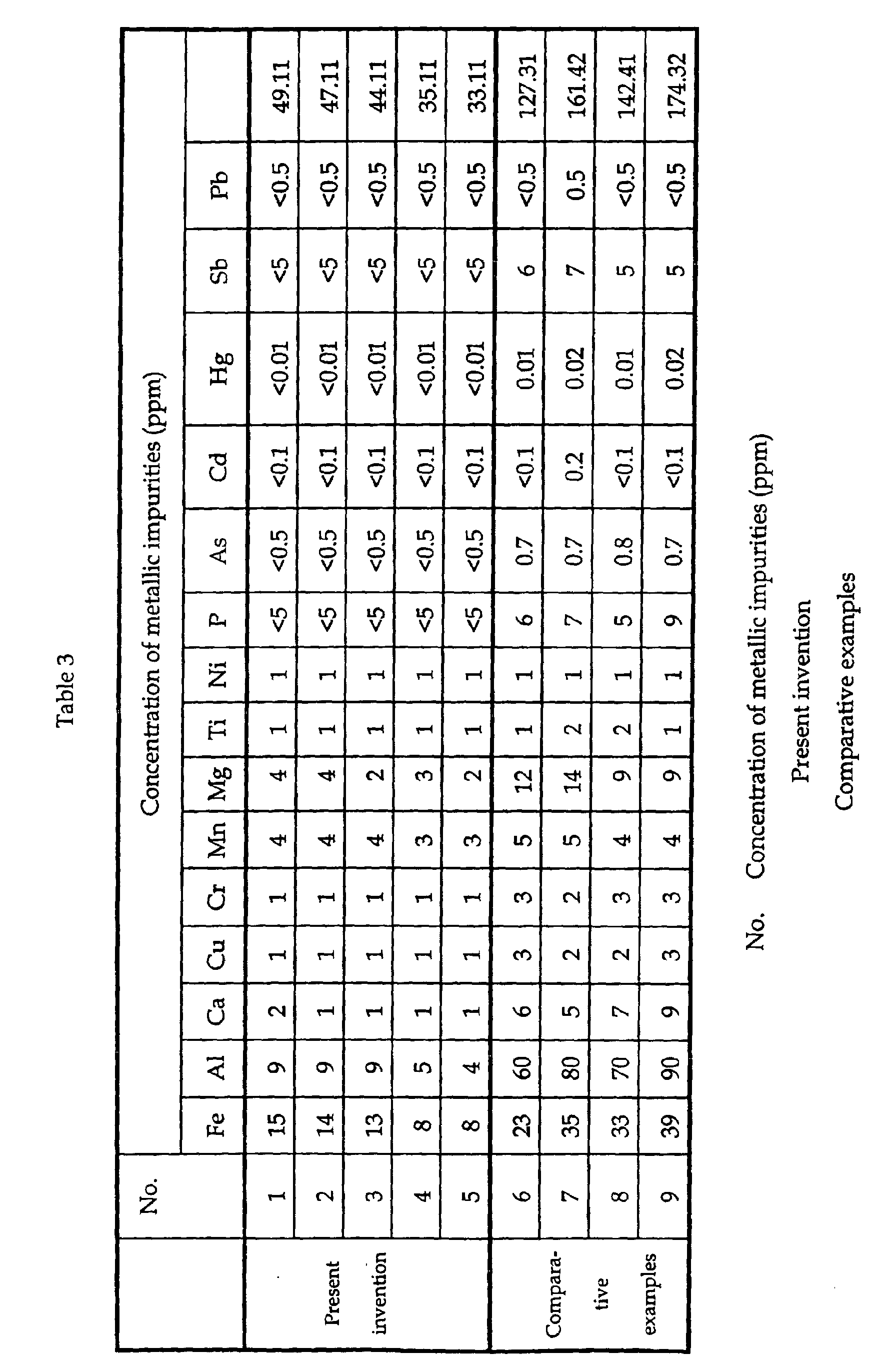

### INDUSTRIAL APPLICABILITY

With the present invention, by making either or both conditions out of the particle size and the mixing ratio of the raw material powder be in a prescribed range, a high-quality silicon monoxide vapor deposition material can be produced efficiently.

According to the present invention, when producing the silicon monoxide vapor deposition material, by carrying out degassing treatment on the raw material in the raw material chamber at a low temperature before the silicon monoxide is generated, a silicon monoxide vapor deposition material having excellent duality with a high bulk density and a high hardness can be obtained. Moreover, splashing can be inhibited when forming a silicon oxide vapor-deposited film having a gas barrier ability, and hence if the silicon monoxide vapor deposition material according to the present invention is used, a packaging material having an excellent gas barrier ability can be produced.

According to the production apparatus according to the present invention that uses a vacuum deposition method and has a partition member between the raw material chamber and the deposition chamber, unreacted fine powder generated through splashing arising in the raw material chamber can be prevented from getting into the deposition chamber, and hence a high-purity silicon monoxide vapor deposition material having a low amount of metallic impurities that are harmful to the human body can be obtained. Consequently, if the silicon monoxide vapor deposition material according to the present invention is used, then a high-quality packaging material having an extremely low amount of impurities as required to a high standard for use with foodstuffs, medical supplies, medicines and so on can be provided.

## Claims

1. A silicon monoxide vapor deposition material, having an average bulk density of 2.0g/cm³ or more , and a Vickers hardness of 500 or more.

2. A silicon monoxide vapor deposition material, having a total amount of metallic impurities of 50ppm or less.

3. A silicon monoxide vapor deposition material, having an average bulk density of 2.0g/cm³, a Vickers hardness of 500 or more, and a total content of metallic impurities of 50ppm or less.

4. A process for producing a silicon monoxide vapor deposition material, comprising a degassing treatment step of holding a mixed granulated body of metallic silicon powder and silicon dioxide powder or a solid silicon monoxide raw material for 0.5 to 4.0 hours at 800 to 1200°C in a vacuum atmosphere, followed by a sublimation step of raising the temperature of the raw material to generate gaseous silicon monoxide.

5. A process for producing a silicon monoxide vapor deposition material, comprising a sublimation step of raising the temperature of a mixed granulated body of metallic silicon powder and silicon dioxide powder or a solid silicon monoxide raw material to generate gaseous silicon monoxide, followed by a step of passing the sublimated gas into and through a perforated passage to remove unreacted fine powder.

6. A process for producing a silicon monoxide vapor deposition material, comprising a degassing treatment step of holding a mixed granulated body of metallic silicon powder and silicon dioxide powder or a solid silicon monoxide raw material for 0.5 to 4.0 hours at 800 to 1200°C in a vacuum atmosphere, followed by a sublimation step of raising the temperature of the raw material to generate gaseous silicon monoxide, and a step of passing the sublimated gas into and through a perforated passage to remove unreacted fine powder.

7. A process for producing a silicon monoxide vapor deposition material, comprising a step of forming metallic silicon powder and silicon dioxide powder having an average particle size in a range of 1 µm to 40 µm into a mixed granulated body.

8. A process for producing a silicon monoxide vapor deposition material, comprising a step of forming metallic silicon powder and silicon dioxide powder into a mixed granulated body with a mixing ratio in a range of 0.90 to 0.99 as a molar ratio (silicon dioxide / metallic silicon).

9. A process for producing a silicon monoxide vapor deposition material, comprising a step of forming metallic silicon powder and silicon dioxide powder having an average particle size in a range of 1 m to 40 m into a mixed granulated body with a mixing ratio in a range of 0.90 to 0.99 as a molar ratio (silicon dioxide / metallic silicon).

10. The process for producing a silicon monoxide vapor deposition material according to any of claims 7 through 9, wherein the mixed granulated body has an average particle size of 1 to 30mm.

11. A raw material for producing a silicon monoxide vapor deposition material, comprising a mixed granulated body of metallic silicon powder and silicon dioxide powder having an average particle size in a range of 1 µm to 40 µm.

12. A raw material for producing a silicon monoxide vapor deposition material, comprising a mixed granulated body of metallic silicon powder and silicon dioxide powder with a mixing ratio in a range of 0.90 to 0.99 as a molar ratio (silicon dioxide / metallic silicon).

13. A raw material for producing a silicon monoxide vapor deposition material, comprising a mixed granulated body of metallic silicon powder and silicon dioxide powder having an average particle size in a range of 1 m to 40 m with a mixing ratio in a range of 0.90 to 0.99 as a molar ratio (silicon dioxide / metallic silicon).

14. An apparatus for producing a silicon monoxide vapor deposition material, in which, in a vacuum deposition apparatus, perforated passage means for passing a sublimated gas into and through a perforated passage to remove unreacted fine powder is disposed between a raw material chamber in which a sublimation step is carried out on a raw material for producing the silicon monoxide vapor deposition material and a deposition chamber in which a vapor deposition step is carried out.

15. The apparatus for producing a silicon monoxide vapor deposition material according to claim 14, wherein the perforated passage means comprises a single plate having a plurality of gas flow holes formed therein, or a partition plate in which such single plates are placed on top of one another with prescribed spacing therebetween.

16. The apparatus for producing a silicon monoxide vapor deposition material according to claim 14, wherein the perforated passage means comprises a single plate of a porous material, or a laminate in which such single plates are placed on top of one another with prescribed spacing therebetween.
